(19) Europäisches Patentamt / European Patent Office / Office européen des brevets

(11) **EP 1 897 978 A1**

(12) **EUROPEAN PATENT APPLICATION**

(43) Date of publication:
**12.03.2008 Bulletin 2008/11**

(51) Int Cl.:
*C30B 29/40* (2006.01)  *H01L 21/306* (2006.01)

(21) Application number: **07016218.5**

(22) Date of filing: **17.08.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **05.09.2006 JP 2006239764**

(71) Applicant: **Sumitomo Electric Industries, Ltd.**
**Chuo-ku**
**Osaka 541 0041 (JP)**

(72) Inventors:
• **Ishibashi, Keiji**
**Itami-shi,**
**Hyogo 664-0016 (JP)**
• **Irikura, Masato**
**Itami-shi,**
**Hyogo 664-0016 (JP)**
• **Nakahata, Seiji**
**Itami-shi,**
**Hyogo 664-0016 (JP)**

(74) Representative: **Grünecker, Kinkeldey,**
**Stockmair & Schwanhäusser**
**Anwaltssozietät**
**Maximilianstrasse 58**
**80538 München (DE)**

(54) **Manufacturing method of group III nitride substrate, group III nitride substrate, group III nitride substrate with epitaxial layer, group III nitride device, manufacturing method of group III nidtride substrate with epitaxial layer, and manufacturing method of group III nitride device**

(57)    A manufacturing method of a group III nitride substrate (1, 2) by which a group III nitride substrate (1, 2) being excellent in flatness can be obtained includes the steps of: adhering a plurality of the stripe type group III nitride substrates to an abrading holder (53) so that a stripe structure direction is perpendicular to a rotation direction of the abrading holder (53); and grinding, lapping and/or polishing the substrates (1,2).

FIG.8

**Description**

BACKGROUND OF THE INVENTION

Field of the Invention

The present invention relates to a method of grinding and abrading a gallium nitride (GaN), aluminum nitride (AlN), or aluminum-gallium nitride (AlGaN) substrate having a stripe structure, as adhered to an abrasive plate. The substrate crystals each include nitride as a group V element and respectively include different group III elements. Therefore, they are collectively referred to as the group III nitride. None of them can be grown from a liquid phase. A substrate is manufactured by a scheme in which a thick film is formed on a ground substrate through vapor phase deposition and then the ground substrate is removed.

Grinding is a process of reducing the thickness by abrading the surface using coarse abrasive grain. Abrading includes lapping and polishing. Lapping is a process of reducing the thickness more slowly, improving surface roughness and reducing a work-affected layer using fine bonded abrasive grain or coarse loose abrasive grain. Polishing is a process of further smoothening the surface and further reducing the work-affected layer using fine loose abrasive grain. CMP (Chemical Mechanical Polishing) is polishing utilizing the chemical effect of agents and the physical effect of abrasive grain.

A Si wafer (substrate) is strong and tough, and easily ground, lapped or polished. On the other hand, a GaN wafer (substrate) is harder than the Si wafer but is more brittle and weak to shock. The group III nitride substrate cannot be ground, lapped or polished in a same manner as the Si wafer. Accordingly, the group III nitride requires special grindstone, abrasive liquid, abrasive cloth and the like.

As to abrading and/or grinding of a semiconductor substrate, in some cases both sides thereof are abraded and/or ground, and in some cases single side thereof is abraded and/or ground. Herein the single-side abrading and/or grinding is described. In the single-side abrading, the wafer (substrate) as adhered to a disc-like abrasive plate (also referred to as a holder) is pressed against the abrasive cloth of the surface plate. The lower side of the wafer is abraded while the abrasive plate is rotated on its own axis and the surface plate is revolved about a prescribed point, with the abrasive liquid being supplied. When it is necessary to abrade both sides, the same process is repeated for both sides.

There is another double-side abrading method. In the method, a plurality of jigs, i.e., carriers, having several holes and having teeth along its circumference are placed between upper and lower surface plates. The teeth of the carriers are meshed with the sun gear and the internal gear. The carriers are caused to perform planetary movement while an abrasive liquid is poured from a groove in the upper surface plate, whereby both sides of the wafer are abraded simultaneously. The present invention does not employ this method, and the present invention is directed to an improvement of a method of abrading a single side of the wafer at a time, while fixing the wafer to the abrasive plate.

In the present invention, a stripe structure is an essential condition of the wafer. This structure is not present in a Si wafer, GaAs wafer and the like. This structure is obtained when a group III nitride substrate such as gallium nitride is manufactured by a special scheme. A stripe wafer is an anisotropic wafer in which parallel structures extending in a certain direction of the wafer are repeatedly present.

The wafers having the stripe structure are: a wafer in which a crystal defect gathering region H where dislocations gather and a low defect single crystal region Z where dislocations are substantially not present are alternately present parallel to each other ((HZ) m type); and a wafer in which a pair of crystal defect gathering region H where dislocations gather and low defect single crystal region Z where dislocations are substantially not present and a pair of a C-plane growth region Y and low defect single crystal region Z are alternately present parallel to each other ((HZYZ) m type). The present invention is directed to grinding, lapping, and polishing of the stripe wafers.

Description of the Background Art

It is difficult to manufacture large size substrates of a group III nitride crystal such as a gallium nitride (GaN) crystal. Nitride gallium wafers measuring at least 40 mm diameter are yet to be manufactured in a large amount and at low costs. Since the GaN crystal substrate itself is new, an appropriate abrading method is yet to known. GaN is harder than Si and grinding or abrading is difficult. Nonetheless, GaN is brittle, whereby grinding or abrading is further difficult. Generally, manufacturing of group III nitride crystal substrates is difficult. Furthermore, their hardness and brittleness makes abrading difficult.

There are substantially no conventional technique related to the abrading method. Accordingly, no conventional technique related to the single-side abrading of a GaN, AlN, AlGaN, InGaN, or InN substrate can be cited herein. A small GaN crystal substrate measuring some millimeter diameter is useless for manufacturing a device. The present invention is directed to a group III nitride semiconductor substrate measuring at least 40 mm diameter. In particular, the one measuring at least 50 mm diameter is important.

Japanese Patent Laying-Open No. 2004-165360 relates to the single-side abrading of a GaAs wafer. Liquid wax is sprayed onto an abrasive plate (abrading holder) and a GaAs wafer is pressed against the abrasive plate (abrading holder) so as to be fixed. It proposes an adhesion method, which is a preparation stage in the single-side abrading of GaAs wafers. There are numerous improvements as to the abrading technique of Si wafers or GaAs wafers, but there are substantially no improvements as to group III nitride substrates.

The present invention relates to a method of abrading a substrate having the stripe structure. The stripe structure is not produced by a general scheme, but by a unique method of the present inventors. Therefore, firstly the stripe structure must be described. The stripe structure is an anisotropic structure, in which crystal defect gathering regions H where many dislocations (defects) gather in a high density and low defect single crystal regions Z, which is a single crystal and of a low defect density, i.e., dislocations are substantially not present, are alternately present parallel to each other in a large number. The portion having a low defect density and being a single crystal can be classified into two.

One is low defect single crystal region Z, which contacts crystal defect gathering region H and which has high conductivity. The other is C-plane growth region Y, which does not contact crystal defect gathering region H and which has low conductivity. H, Z and Y are parallel to each other and repeatedly present (Figs. 1 and 2). In some cases Y is not present (Figs. 3 and 4). Since H, Z and Y, or H and Z, are parallel to each other, this structure is referred to as the parallel structure.

In order to understand the stripe structure, knowledge of a unique growth method by the present inventors, which should be referred to as the facet growth method, is necessary. Gallium nitride is produced by the vapor phase deposition on a ground substrate (such as a sapphire substrate). In a conventional manner, a gallium nitride thin film is grown while the growth condition is carefully controlled and C-plane is maintained. Japanese Patent Laying-Open No. 2001-102307 proposes the facet growth method firstly discovered by the present inventors. Gallium nitride crystal nucleuses are produced on a ground substrate. When the crystal nucleuses start to grow, initially a surface not being flat but with many recesses and protrusions due to individually grown crystal grains is formed. As the growth progresses, a film is formed to be a flat gallium nitride thin film.

The facet growth method is a unique and new scheme in which the surface is not flattened but recesses and protrusions (formed by facets) are maintained through the growth. When many pits (recesses) of facets are formed on the gallium nitride and maintained, due to the difference in the growth rates between lateral and longitudinal directions, the facets having been at the upper portion move to the bottom of the facet pit. At the pit bottom, the dislocations converge at a high density. The dislocations are eliminated from the other portions, and therefore the dislocation density of the other portions becomes low. Since where the pits are produced is unknown in Japanese Patent Laying-Open No. 2001-102307, this is referred to as the random type.

Japanese Patent Laying-Open No. 2003-165799 discloses an invention that can clearly expect the position where a pit is produced. On a ground substrate (sapphire, GaAs), masks of $SiO_2$ are formed in a manner of isolated dots and in a sixfold symmetry. GaN is grown thereon through vapor phase deposition (HVPE). The facet is formed so that the pit bottom is always positioned immediately above the mask. Since each mask and pit are arranged in a manner of an isolated dot, this is referred to as the dot type. The portion over the mask becomes crystal defect gathering region H. The other regions becomes low defect single crystal region Z or C-plane growth region Y. According to this invention, it becomes possible to determine in advance which portion is to be H, Z or Y. In order to form a device such as a light emitting element, it is necessary to determine the position of a chip so as not to include crystal defect gathering region H.

With the dot type, it is difficult to continuously determine the position of light-emitting element chips on a wafer. Accordingly, Japanese Patent Laying Open No. 2003-183100 proposes a scheme in which parallel linear masks are provided on a ground substrate, on which GaN is grown through vapor phase deposition. The growth over the mask is delayed and hence becomes the bottom of a facet. The portion above the mask becomes crystal defect gathering region H.

By the facets, dislocations are transferred to crystal defect gathering region H. The dislocations converge at crystal defect gathering region H over the mask. The portions not positioned over the mask become low defect single crystal region Z or C-plane growth region Y.

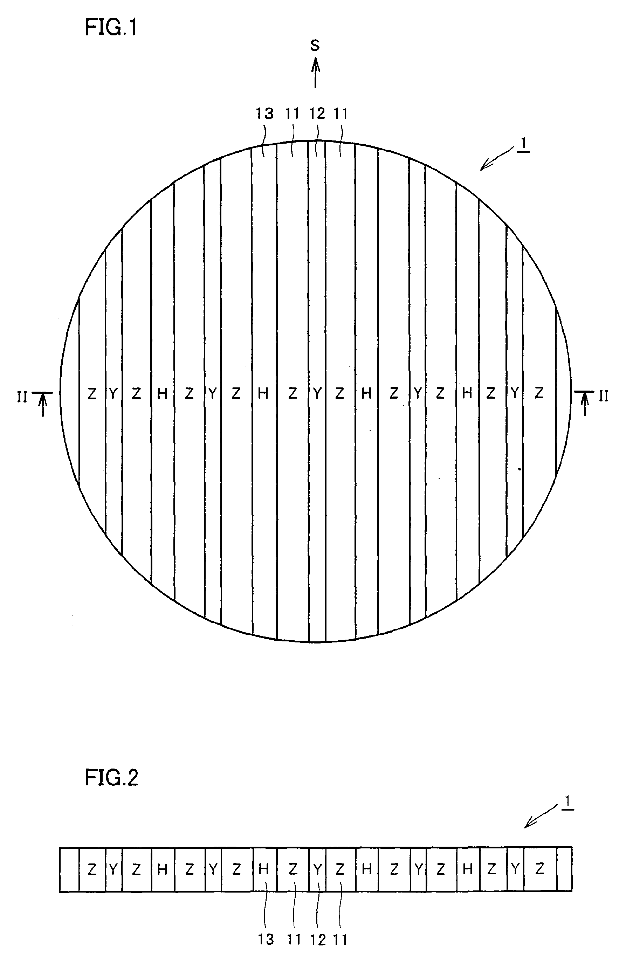

Figs. 1 and 2 show a substrate 1, which is a stripe wafer of such a shape. Fig. 1 is a plan view, while Fig. 2 is a longitudinal cross-sectional view along line II-II in Fig. 1. Since the masks are linear and parallel, a crystal defect gathering region 13, a low defect single crystal region 11 and a C-plane growth region 12 are also linear and parallel. A stripe wafer of HZYZHZY... type is obtained. Low defect single crystal region 11 and C-plane growth region 12 are used as light emitting elements. Since low defect single crystal region 11 and C-plane growth region 12 are present linearly, distribution of light emitting elements on the wafer is successfully determined, and thus it is advantageous. It is noted that, because of the variations in the growth conditions such as the temperature of crystal growth, gas flow and the like, the width of the regions may vary to some extent and the shape may more or less deform from the linear and parallel shape.

A wafer of stripe type is proposed in Japanese Patent Laying Open No. 2003-183100, in which width h of crystal defect gathering region H is 1 μm - 200 μm. When the wafer has a quadruple structure in which three regions of low defect single crystal region Z (width z), C-plane growth region Y (width y), and low defect single crystal region Z are interposed between adjacent H, H (HZYZHZYZH... : abbreviated as (HZYZ)m), 2z + y is 10 $\mu$m - 2000 $\mu$m. Pitch p = 2z + y + h is 20 $\mu$m - 2000 $\mu$m.

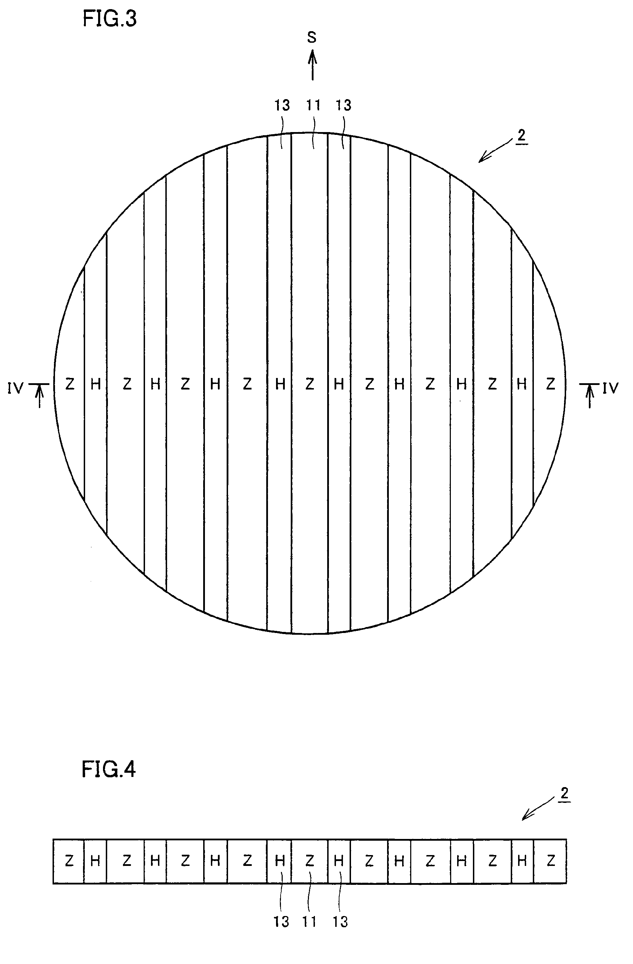

Figs. 3 and 4 show a substrate 2 that is a stripe wafer constituted of HZ. Fig. 3 is a plan view while Fig. 4 is a longitudinal cross-sectional view along line IV-IV in Fig. 3. When the wafer has a double structure in which only one region of low defect single crystal region 11 (width z) is interposed between adjacent crystal defect gathering regions 13, 13 (HZHZHZ... : abbreviated as (HZ)m), z is 10 $\mu$m - 2000 $\mu$m. A pitch p = z + h is 20 $\mu$m - 2000 $\mu$m. Since pitch p defines the width of a device, it is determined by the width of an element. For example when p = 400 $\mu$m, it is suitable for manufacturing devices such as LD and LED of 300 $\mu$m- 350 $\mu$m square.

It has long been tried to manufacture group III nitride crystal substrates of excellent quality. It is now possible to manufacture a GaN free-standing crystal substrate of a low dislocation density measuring 50 $\phi$ (diameter 50 mm), by the facet growth method. The facet growth is effective to attain low dislocation density. Additionally, it becomes possible to know in advance what position has what structure. Therefore, it is advantageous for manufacturing devices. The stripe type GaN is produced by a method in which masks are applied parallel to each other on a ground substrate to perform growth. What is obtained by removing the ground substrate has a repetition structure of ZHZHZH... (HZ)m, or a repetition structure of ZHZYZHZYZH...: (HZYZ)m.

Low defect single crystal region 11 and C-plane growth region 12 have a low dislocation density and are single crystal. The front surface thereof is Ga plane (including GaAl, Al, InAl plane: (0001) plane), and is robust. They are chemically and physically strong, and therefore they are not easily corroded. Crystal dislocation gathering region 13 has a high dislocation density. It is also a single crystal, but its orientation is different by 180°. The front surface of crystal defect gathering region 13 is N-plane (nitrogen plane: (000-1) plane). Crystal defect gathering region 13 is easily corroded by chemical agents. Additionally, it is easily ground and/or abraded. Crystal defect gathering region 13 and low defect single crystal region 11 are significantly different in their characteristics. Conversely, the rear surface of low defect single crystal region 11 is N-plane and the rear surface of crystal defect gathering region 13 is Ga plane.

The stripe type wafer is anisotropic and uneven as described above. It has been found that such anisotropy and unevenness require consideration of the anisotropy in abrading. The present invention proposes a method of abrading the stripe type group III nitride wafers.

Often, the stripes are formed parallel to <1-100> direction. This direction is parallel to {11-2n} facet, which is easily formed. The cleavage plane is {1-100}, which is perpendicular to <1-100> direction of the stripes.

Alternatively, the stripes can be formed parallel to <11-20> direction. In this case, the facet is {1-10n}. The cleavage plane {1-100} is parallel to the stripes.


SUMMARY OF THE INVENTION


A manufacturing method of a group III nitride substrate according to the present invention includes the steps of: adhering a plurality of the stripe type group III nitride substrates to an abrading holder so that a stripe structure direction is perpendicular to a rotation direction of the abrading holder; and grinding, lapping and/or polishing the substrates.

In the manufacturing method of a group III nitride substrate, preferably, in the step of polishing the substrates, the substrates are polished by: using an abrading surface plate having a pad of which compressibility is 1 % - 15 %; setting pressure applied from the pad of the abrading surface plate to the substrates to 100 g/cm$^2$ (9.8 kPa) - 1500 g/cm$^2$ (147 kPa); and rotating the abrading holder and the abrading surface plate while supplying an abrasive liquid of which pH is 1-12.

In the manufacturing method of a group III nitride substrate, preferably, a range of the compressibility of the pad is 1 % - 10 %.

In the manufacturing method of a group III nitride substrate, preferably, the pressure applied from the pad to the substrates is 300 g/cm$^2$ (29.4 kPa) - 1000 g/cm$^2$ (98 kPa).

In the manufacturing method of a group III nitride substrate, preferably, pH of the abrasive liquid is pH = 1.5 - 10.

In the manufacturing method of a group III nitride substrate, preferably, pH of the abrasive liquid is pH = 2 - 7.

In the manufacturing method of a group III nitride substrate, preferably, acid added to the abrasive liquid for adjusting pH is organic acid or salt of organic acid.

A group III nitride substrate according to the present invention is prepared through a vapor phase deposition method. The substrate includes a stripe structure, in which: a crystal defect gathering region that has dislocations gathered therein and that has a nitrogen plane as its top plane; and a low defect single crystal region that is lower in a dislocation density than the crystal defect gathering region and that has a group III element plane as its top plane, are repeatedly aligned in a linear and parallel manner. The substrate is obtained by polishing the substrate by: using an abrading surface plate having a pad of which compressibility is 1 % - 15 %; setting pressure applied from the pad of the abrading surface plate to the substrate to 100 g/cm$^2$ (9.8 kPa) - 1500 g/cm$^2$ (147 kPa); and rotating the abrading holder and the abrading surface plate while supplying an abrasive liquid of which pH is 1-12. Flatness, which is a proportion of an area having an off angle of less than 0.1° relative to a direction perpendicular to the stripe structure, is at least 40 %. Surface roughness is at most Ra 2 nm.

A group III nitride substrate according to the present invention is prepared through a vapor phase deposition method. The substrate includes a stripe structure, in which: a crystal defect gathering region that has dislocations gathered therein and that has a nitrogen plane as its top plane; a low defect single crystal region that is lower in a dislocation density than the crystal defect gathering region and that has a group III element plane as its top plane; and a C-plane growth region Y, are repeatedly aligned in a linear and parallel manner. The substrate is obtained by polishing the substrate by: using an abrading surface plate having a pad of which compressibility is 1 % - 15 %, setting pressure applied from the pad of the abrading surface plate to the substrate to 100 g/cm$^2$ (9.8 kPa) - 1500 g/cm$^2$ (147 kPa); and rotating the abrading holder and the abrading surface plate while supplying an abrasive liquid of which pH is 1-12. Flatness, which is a proportion of an area having an off angle of less than 0.1° relative to a direction perpendicular to the stripe structure, is at least 40 %. Surface roughness is at most Ra 2 nm.

The group III nitride substrate according to the present invention is, preferably, obtained by polishing the substrate as adhered to the abrading holder so that a direction of the stripe structure is perpendicular to a direction of rotation of the abrading holder.

A group III nitride substrate with an epitaxial layer according to the present invention includes: the group III nitride substrate according to the aforementioned present invention; and at least one layer of a group III nitride layer formed by epitaxial growth on at least one main surface of the substrate.

A group III nitride device according to the present invention includes: the group III nitride substrate according to the aforementioned present invention; at least one layer of a group III nitride layer formed by epitaxial growth on at least one main surface of the substrate; and an electrode formed at the substrate or the group III nitride layer.

A manufacturing method of a group III nitride substrate with an epitaxial layer according to the present invention includes the steps of: preparing the group III nitride substrate according to the aforementioned present invention; and epitaxially growing a group III nitride layer on at least one main surface of the substrate.

A manufacturing method of group III nitride device according to the present invention includes the steps of: preparing the group III nitride substrate according to the aforementioned present invention; epitaxially growing a group III nitride layer on at least one main surface of the substrate; and forming an electrode at the substrate or the group III nitride layer.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a schematic plan view showing a configuration of a group III nitride substrate in one embodiment of the present invention.
Fig. 2 is a schematic cross-sectional view along line II-II in Fig. 1.
Fig. 3 is a schematic plan view showing a configuration of a group III nitride substrate in one embodiment of the present invention.
Fig. 4 is a schematic cross-sectional view along line IV-IV in Fig. 3.

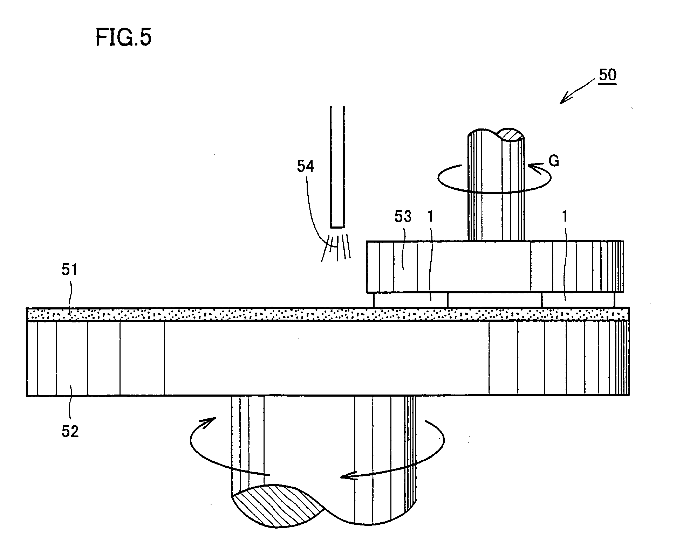

Fig. 5 is a schematic view showing a configuration of an abrading apparatus in one embodiment of the present invention.

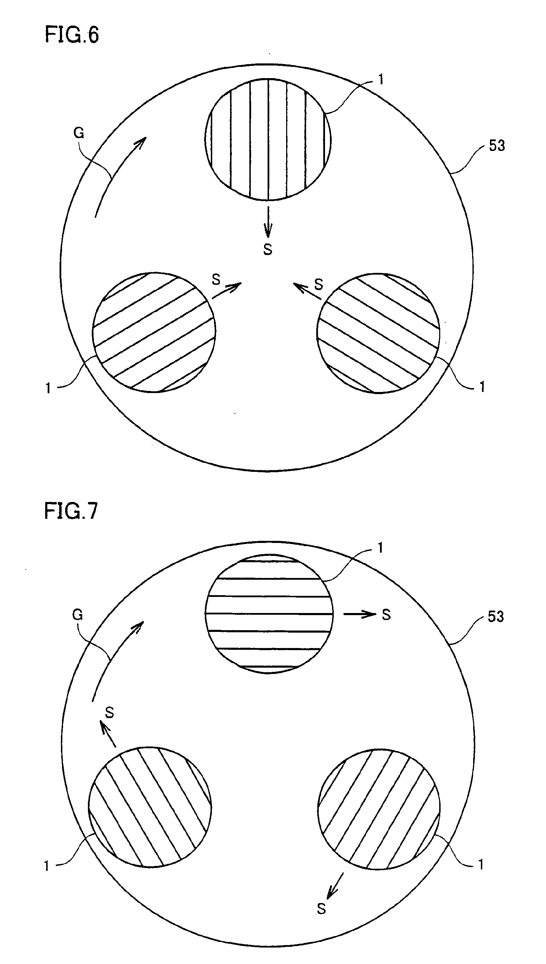

Fig. 6 is a schematic plan view related to a description of a manufacturing method of a group III nitride substrate in one embodiment of the present invention.
Fig. 7 is a schematic plan view related to a description of a manufacturing method of a group III nitride substrate which is not in the scope of the present invention.

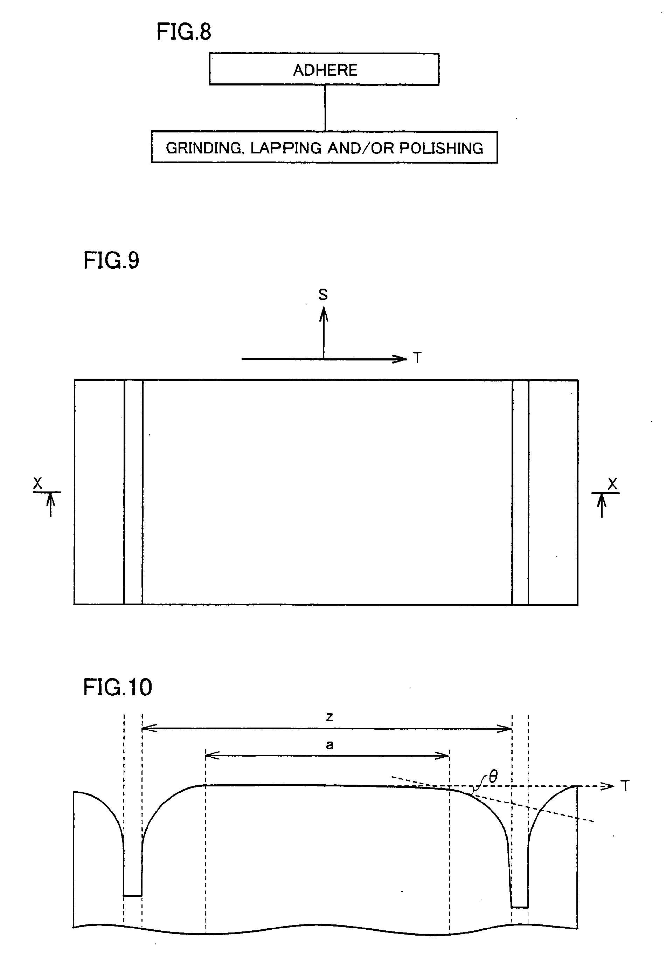

Fig. 8 is a flowchart schematically showing a manufacturing method of a group III nitride substrate in one embodiment of the present invention.
Fig. 9 is a schematic partial plan view showing as enlarged a substrate after polishing.
Fig. 10 is a schematic partial cross-sectional view along line X-X in Fig. 9.

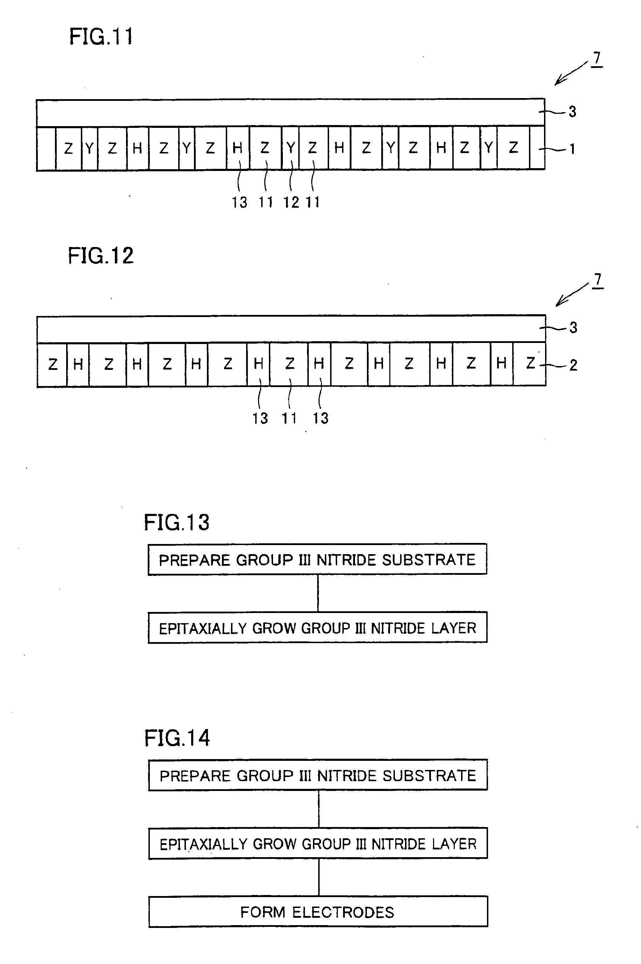

Fig. 11 is a schematic cross-sectional view showing a configuration of a group III nitride substrate with an epitaxial layer in one embodiment of the present invention.
Fig. 12 is a schematic cross-sectional view showing a configuration of a group III nitride substrate with an epitaxial layer in one embodiment of the present invention.
Fig. 13 is a flowchart schematically showing a manufacturing method of a group III nitride substrate with an epitaxial layer in one embodiment of the present invention.

Fig. 14 is a flowchart schematically showing a manufacturing method of a group III nitride device in one embodiment of the present invention.

DESCRIPTION OF THE PREFERRED EMBODIMENTS

Fig. 5 schematically shows a configuration of an abrading apparatus. Referring to Figs. 1 and 5, an abrading apparatus 50 provided with an abrading surface plate 52 having a pad of which compressibility is 1% - 15% is used. A plurality of stripe type group III nitride substrates 1 (wafers) are radially adhered to an abrading holder 53 so that stripe direction S is perpendicular to rotation direction G of abrading holder 53. The pressure applied from abrading holder 53 to substrates 1 is set to 100 g/cm$^2$ (9.8 kPa) - 1500 g/cm$^2$ (147 kPa). Substrates 1 are abraded while abrading holder 53 and abrading surface plate 52 are rotated, with abrasive liquid 54 of which pH is 1-12 being supplied.

The adhering manner by which stripe direction S is perpendicular to rotation direction G is shown in Fig. 6. The adhering manner by which stripe direction S is parallel to rotation direction G is shown in Fig. 7. The present invention is directed to the adhering manner of substrates 1 to abrading holder 53 as shown in Fig. 6. This adhering manner by which stripe direction S is perpendicular to rotation direction G is applied similarly to grinding, lapping and polishing.

That is, the manufacturing method of substrate 1 being a group III nitride substrate in one embodiment of the present invention, as shown in Fig. 8, includes a step of adhering to abrading holder 53 a plurality of substrates 1 being stripe type group III nitride substrates so that stripe structure direction S is perpendicular to rotation direction G of abrading holder 53, and a step of grinding, lapping and/or polishing substrates 1.

More desirably, the range of the compressibility of pad 51 is 1 % - 10 %. More preferably, the range is 1 % - 3 %.

More preferably, the pressure applied from pad 51 to substrates 1 is 300 g/cm$^2$ (29.4 kPa) - 1000 g/cm$^2$ (98 kPa).

More preferably, the range of pH of abrasive liquid 54 is pH = 1.5 - 10. Further suitably, pH = 2-6. It is desirably acid. Alkali selectively corrodes a crystal defect gathering region 13. This produces protrusions and recesses on the surface. Accordingly, acid abrasive liquid 54 is suitable.

When employing an acid abrasive liquid, inorganic acid such as hydrochloric acid, sulfuric acid, nitric acid or the like can be used. Organic acid such as citric acid, malic acid or the like can also be used. Organic acid has a weak effect and does not corrode crystal defect gathering region 13, and therefore advantageous in maintaining the flatness of substrates 1. Inorganic acid and organic acid may be salts of inorganic acid and salts of organic acid, as combined with metal elements.

Indices for evaluating a mirror wafer after grinding, lapping and polishing are flatness, over-abraded circumference, surface roughness and the like.

Flatness means the proportion of the area having an off angle $\theta$ of less than 0.1° relative to the total area of low defect single crystal region 11 (including C-plane growth region 12, if any). The off angle is an angle formed between direction T perpendicular to stripe direction S and the surface of the substrate (wafer). Now, substrate 11 that is a stripe type substrate having the (HZ)m structure shown in Figs. 3 and 4 is described. Referring to Figs. 8 and 9, which are the enlarged views of the substrate after polishing, from the ratio between width z of low defect single crystal region 11 and width a of the region having an off angle $\theta$ of less than 0.1° in the cross-sectional view along direction T perpendicular to stripe direction S, the flatness is expressed by the following expression:

$$\text{Flatness (\%)} = a \, / \, z \times 100$$

Flatness 80 % means that the area having an off angle $\theta$ of less than 0.1° in direction T perpendicular to the stripes occupies 80 % of the total low defect single crystal region 11. Herein, the definition is different than the normal wafer flatness.

Flatness is an index for evaluating a wafer, and it is not a definition of grinding, lapping and polishing. Only the flat portion can be used for manufacturing devices. That is, in a wafer having low flatness, the area that can be used for manufacturing devices is small. The present invention requires that the flatness of a wafer after abrading is at least 40 %. Further preferably, it is at least 60 %. Still further preferably, it is at least 80 %.

Over-abraded circumference means that the circumference of a wafer is abraded and thus becomes lower than the surface, whereby the whole wafer is formed in a convex shape. This also reduces the effective area. On the other hand, flatness is slightly different from over-abraded circumference. As to the stripe structure, since crystal defect gathering region 13 is physically and chemically weak, in some cases it becomes a recess by grinding, lapping and polishing. This is evaluated by the flatness. As the recess herein is the one formed at each crystal defect gathering region 13, it is different from over-abraded circumference that is limited to the circumference.

Surface roughness is also an evaluation index of a mirror wafer. There are various surface roughness such as Rmax, Ra, Rz, Ry, Rms (JIS standard) and the like. Herein, Ra is employed as an index of surface roughness. It is obtained as an average of absolute values of differences between crests and troughs formed on the wafer surface. The extent of demand for the surface roughness varies depending on the purpose. The present invention requires that the Ra of a wafer after polishing is at most Ra 2.0 nm. More desirably, it is at most Ra 0.9 nm.

In some cases, an epitaxial wafer in which a group III nitride layer is epitaxially grown on the mirror wafer is manufactured to examine photoluminescence (PL) intensity for evaluation.

In some cases, a device is manufactured by epitaxially growing a group III nitride layer on the mirror wafer and providing electrodes. By actually supplying power to the device so that it emits light, the performance of the device is examined. Thus, how the wafer is finished is checked. When devices are manufactured, the proportion of conforming devices is referred to as a yield. The same wafer provides different yields depending on the target device. The present invention requires that the yield when manufacturing blue laser (430 nm) is at least 35 %.

If stripe direction S of a group III nitride crystal wafer (substrate 1 or 2) having the stripe structure is oriented parallel to rotation direction G of abrading holder 53, physically and chemically weak crystal defect gathering region 13 is selectively abraded and/or polished. This results in poor flatness and surface roughness. In contrast, according to the present invention wafers are adhered so that stripe direction S is perpendicular to rotation direction G of abrading holder 53. Since abrading holder 53 is rotated on its own axis and abrading surface plate 52 is revolved about a prescribed point, not always the relative movement direction between substrate 1 and pad 51 is rotation direction G of abrading holder 53.

On the other hand, when averaged for a period of time, it can be seen that the relative movement direction between substrate 1 and pad 51 is rotation direction G of abrading holder 53. Pad 51 relatively moves with reference to substrate 1 so as to be perpendicular to stripe direction S of substrate 1, and therefore the particularly weak crystal defect gathering region 13 is not selectively corroded and abraded. Therefore, according to the present invention, the reduced amounts of low defect single crystal region 11, crystal defect gathering region 13 and C-plane growth region 12 are averaged and the flatness is maintained. Surface roughness can also be prevented from becoming poor.

Setting of pH of abrasive liquid 54 is also important. The strong alkaline abrasive liquid selectively erodes crystal defect gathering region 13 that is chemically weak. Accordingly, crystal defect gathering region 13 is recessed. This results in poor flatness and surface roughness of substrate 1. Therefore, the pH range of abrasive liquid 54 is 1-12. More preferably, the pH range of abrasive liquid 54 is 1.5-10. Selective corrosion of crystal defect gathering region 13 is small when acid abrasive liquid 54 is employed and, therefore, more preferably the range is 2-6. Thus, respective thicknesses of low defect single crystal region 11, crystal defect gathering region 13 and C-plane growth region 12 are reduced in substantially the same proportion, whereby the flatness is maintained and the surface roughness is low. Strong acid of pH < 1 is not preferable, since crystal defect gathering region 13 is also corroded to form a recess.

If the compressibility of pad 51 is too high, pad 51 enters a recess formed by corroded crystal defect gathering region 13, whereby reduction in the thickness of crystal defect gathering region 13 further progresses. On the other hand, if the compressibility of pad 51 is low, pad 51 is hard and does not expand and contract. When pad 51 is too hard, a shock is likely to occur and a scratch easily occurs in substrate 1. Substrate 1 may possibly be damaged. Based on such reasons, while lower compressibility of pad 51 is suitable, too much hardness is disadvantageous. Accordingly, the compressibility of pad 51 should be at least 1 %.

Therefore, the compressibility range of pad 51 is 1 % - 15 %. In this range, crystal defect gathering region 13 is not selectively worn. Hence, flatness is protected. More preferably, the compressibility range is 1 % - 10 %. Most preferably, it is 1 % - 3 %. Compressibility of pad 51 can be determined by the following expression, using a thickness $T_1$ that is a thickness one minute after an initial load W, is loaded, and a thickness $T_2$ that is a thickness one minute after the load is increased to load $W_2$:

$$\text{Compressibility (\%)} = (T_1 - T_2) / T_1 \times 100$$

100 g/cm$^2$ is employed as $W_1$, and 1800 g/cm$^2$ is employed as $W_2$.

Pressure is 100 g/cm$^2$ (9.8 kPa) - 1500 g/cm$^2$ (147 kPa). More preferably, pressure is 300 g/cm$^2$ (29.4 kPa) - 1000 g/cm$^2$ (98 kPa).

When a wafer (substrate 1 or 2) is polished under such conditions, a mirror wafer having flatness of at least 40 % and surface roughness of at most Ra 2.0 nm can be obtained.

When a group III nitride layer is epitaxially grown on the mirror wafer, an epitaxial layer having excellent crystallinity and morphology can be formed. When LDs are manufactured, the yield of at least 35 % can be achieved.

The group III nitride mirror wafer (group III nitride substrate) of the present invention can be used as a substrate for semiconductor devices such as follows.

There are semiconductor devices such as light emitting elements (light emitting diodes, semiconductor lasers), electronic elements (rectifiers, bipolar transistors, field effect transistors, HEMTs), semiconductor sensors (temperature sensors, pressure sensors, radiation sensors, visible-ultraviolet light detectors), SAW devices, acceleration sensors, MEMS components, piezoelectric oscillators, resonators, piezoelectric actuators and the like.

Substrate 7 that is a group III nitride substrate with an epitaxial layer in one embodiment of the present invention includes, as shown in Figs. 11 and 12, at least one layer of group III nitride layer 3 epitaxially grown on at least one main surface of substrate 1 or 2 being a group III nitride substrate. Such at least one layer of group III nitride layer 3 is an epitaxial layer which is excellent in morphology and crystallinity on which a further epitaxial layer which is excellent in morphology and crystallinity can easily be formed so as to manufacture semiconductor devices of high performance.

Group III nitride layer 3 is not particularly limited, and for example it may be a $Ga_xAl_yIn_{1-x-y}N$ layer ($0 \leq x$, $0 \leq y$, $x+y \leq 1$). Also, the method of epitaxially growing group III nitride layer 3 is not particularly limited, and for example it may preferably be the HVPE (Hydride Vapor Phase Epitaxy, the same applies hereinafter) method, the MBE (Molecular Beam Epitaxy, the same applies hereinafter) method, the MOCVD (Metal Organic Chemical Vapor Deposition, the same applies hereinafter) method and the like. Before epitaxially growing group III nitride layer 3, etching and/or annealing of substrate 1 or 2 being the group III nitride substrate can be performed in an apparatus for the epitaxial growth, so as to modify the property of the surface of substrate 1 or 2.

A semiconductor device in one embodiment of the present invention includes at least one layer of group III nitride layer 3 formed on at least one main surface of substrate 1 or 2 being a group III nitride substrate, and an electrode formed at the group III nitride substrate (substrate 1 or 2) or group III nitride layer 3. The semiconductor device exhibits a high performance, since it is provided with at least one layer of group III nitride layer 3 which is an epitaxial layer being excellent in morphology and crystallinity on at least one main surface of group III nitride substrate.

A manufacturing method of a group III nitride substrate with an epitaxial layer in one embodiment of the present invention includes, as shown in Fig. 13, a step of preparing substrate 1 or 2 being a group III nitride substrate as a semiconductor device substrate, and a step of epitaxially growing at least one layer of group III nitride layer 3 on at least one main surface of substrate 1 or 2. According to the manufacturing method, a semiconductor device of high performance and long life can be obtained, since at least one layer of group III nitride layer 3 being an epitaxial layer excellent in morphology and crystallinity is formed on at least one main surface of the group III nitride substrate.

A manufacturing method of a semiconductor device in one embodiment of the present invention includes, as shown in Fig. 14, a step of preparing substrate 1 or 2 being a group III nitride substrate as a semiconductor device substrate, a step of epitaxially growing at least one layer of group III nitride layer 3 on at least one main surface of substrate 1 or 2, and a step of forming an electrode at the group III nitride substrate (substrate 1 or 2) or group III nitride layer 3. According to the manufacturing method, a semiconductor device of high performance and long life can be obtained, since at least one layer of group III nitride layer 3 being an epitaxial layer excellent in morphology and crystallinity is formed on at least one main surface of the group III nitride substrate.

Example 1

(The relationship between the wafer adhering direction, stripe direction S and rotation direction G)

An alumina block measuring 13 5 mm outer diameter and 30 mm thickness was employed as an abrading holder (abrasive plate). A wafer (substrate) to be subjected to grinding, lapping and/or polishing was a stripe type GaN substrate measuring 50 mm diameter and 0.5 mm thickness. Crystal defect gathering region 13 had a width h of 50 μm. Low defect single crystal region 11 had a width z of 350 μm. Pitch p was 400 μm. There was no C-plane growth region 12 (y = 0). Three wafers to be simultaneously subjected to grinding, lapping or polishing constituted one set of samples.

The three GaN wafers were adhered to the abrading holder using thermoplastic solid wax. The abrading holder was heated to the temperature higher by 30°C than the softening point of the wax so as to melt the wax. The three stripe GaN wafers were regularly adhered at the position where each periphery was distanced 5 mm from the circumference of the abrading holder (abrasive plate). The adhering direction relative to the stripes is as shown in Table 1.

"Parallel" means that stripe direction S of substrate 1 and rotation direction G of abrading holder 53 are parallel to each other as shown in Fig. 7. "Perpendicular" means that stripe direction S of substrate 1 and rotation direction G of abrading holder 53 are perpendicular to each other as shown in Fig. 6.

Four sample sets (samples 1, 2, 3 and 4) each constituted of three wafers were subjected to grinding. In samples 1 and 3, stripe direction S was perpendicular to rotation direction G (Fig. 6). In samples 2 and 4, stripe direction S was parallel to rotation direction G (Fig. 7).

After substrates 1 were adhered to the abrasive plate (abrading holder 53), samples 1-4 were subjected to grinding with diamond grindstone No. 2000. Samples 3 4 were subjected only to grinding. After grinding, samples 1 and 2 were further subjected to lapping using diamond loose abrasive grain having an average grain size of 2 μm. The maximum scratch depth, thickness of a work-affected layer, flatness after the machine working were measured.

Table 1 shows the measurement result. A scratch is a linear scar made by grinding, abrading and the like. Since samples 3 and 4 were subjected only to grinding with coarse bonded grindstone, scratches were deep. While the maximum scratch depth of sample 4 was 290 nm, the maximum scratch depth of sample 3 was 95 nm.

The thickness of work-affected layer of sample 4 was thick, being 7 μm (average). The thickness of work-affected layer of sample 3 was 4 μm, being reduced substantially by half. This is attributed to the difference in the adhering orientation of stripe direction S to abrading holder 53. It is desirable that the scratch is shallow and the work-affected layer is thin. Sample 3 showed a favorable result than sample 4 Hence, it is preferable that stripe direction S is perpendicular to rotation direction G (which is referred to as S perpendicular G).

Crystal defect gathering region 13 is the site where dislocations densely gather, which is physically and chemically weak. When ground or abraded, it is easily scarred. In contrast, low defect single crystal region 11 and C-plane growth region 12 are hard and sturdy, being physically and chemically robust. They are not easily ground or abraded.

When stripe direction S and rotation direction G are parallel to each other (Fig. 7), the grindstone rubs the surface parallel to the stripes. The difference between crystal defect gathering region 13 and low defect single crystal region 11 constituting the stripes in the physical and chemical strength appears as deep scratches and thick affected layers in grinding or abrading.

When stripe S and rotation direction G are perpendicular to each other (Fig. 6), the grindstone rubs the surface perpendicularly to the stripes, and strong and weak surfaces are alternately arranged in that direction. Thus, owing to the reinforcement by the hard surface, a scar is not easily formed. The difference in physical and chemical strength between crystal defect gathering region 13 and low defect single crystal region 11 constituting the stripes is averaged, and appears as shallow scratches and thin affected layers in grinding or abrading.

Table 1

| | | sample 1 | sample 2 | sample 3 | sample 4 |
|---|---|---|---|---|---|
| working method | | lapping | lapping | grinding | grinding |
| adhesion | adhesion direction | perpendicular | parallel | perpendicular | parallel |
| after machine working | scratch depth (nm) | 21 | 49 | 95 | 290 |
| | work-affected layer (μm) | 0.5 | 2 | 4 | 7 |
| | flatness (%) | 100 | 100 | 100 | 100 |
| after CMP | surface roughness Ra (nm) | 0.5 | 1.4 | - | - |
| | flatness (%) | 65 | 45 | - | - |

Samples 1 and 2 were subjected also to lapping. In lapping, abrasive grain is finer than in grinding. Furthermore, since loose abrasive grain is used, scratches are abraded and become shallow. The maximum scratch depth of sample 1 was 21 nm, and that of sample 2 was 49 nm. The scar was shallow since in sample 1 rotation direction G was perpendicular to stripe direction S, and the regions having high surface hardness and the regions having low surface hardness were alternately present in the grinding and lapping direction. In sample 2, the scratch was deep since rotation direction G was parallel to stripe direction S (referred to as "S parallel G"), and the portion being low in the surface strength was firstly hollowed deeply. The work-affected layer of sample 1 was 0.5 μm, and that of sample 2 was 2 μm. Sample 1 was excellent also in this respect. Since rotation direction G was perpendicular to stripe direction S and the strength was averaged (HZHZH... or, HZYZH...), the affected layer was thin.

Samples 1 and 2 were further subjected to CMP (Chemical Mechanical Polishing) using colloidal silica. After the processing, the surface roughness of sample 1 was Ra 0.5 nm and that of sample 2 was Ra 1.4 nm. The flatness of sample 1 was 65 % and that of sample 2 was 45 %. Flatness is an index of percentage of the area having an off angle of less than 0.1° relative to low defect single crystal region 11. A higher value is better. Sample 1 being "S perpendicular G" was lower in the surface roughness and higher in flatness than sample 2 being "S parallel G". This is because stripe direction S is perpendicular to the rotation direction G of abrading holder 53.

In sample 1, crystal defect gathering region 13 was not recessed after machine abrading, and therefore showed no flatness problem. Among samples 1-4, sample 1 being "S perpendicular G" was the best. Comparing the samples subjected only to grinding, sample 3 was superior to sample 4. This can be explained similarly. That is, since sample 3 was "S perpendicular G", the movement direction of the grindstone crossed crystal defect gathering region 13 and low defect single crystal region 11 and grinding was averaged.

Example 2: The effect of pH of abrasive liquid (inorganic acid and organic acid)

With sample 1 ("S perpendicular G") in Example 1, conditions were varied (six types) and CMP was performed. Specifically, an examination was carried out varying pH of CMP abrasive liquid.

Sample 1 was prepared as follows. On an alumina block measuring 135 mm outer diameter and 30 mm thickness as abrading holder 53, three GaN wafers (substrates) measuring 50 mm $\phi$ diameter and having stripes with 400 $\mu$m pitch were adhered by solid wax so that stripe direction S was perpendicular to rotation direction G (radially). Then grinding and lapping were performed. After grinding and diamond lapping were performed with diamond grindstone No. 2000 (JIS standard R6001 microgrits for precision abrading #2000), CMP was performed under the conditions shown in Table 2. Samples 5-14 were obtained.

For each of the samples 5-14, the loose abrasive grain was colloidal silica ($SiO_2$). pH was 0.8 for sample 5; 1.0 for sample 6; 1.5 for sample 7; 2.0 for samples 8, 9 and 14; and 6.0 for sample 10. That is, they were acid. pH was 10 for sample 11; 12 for sample 12; and 13 for sample 13. That is, they were alkaline. Additives for pH adjustment were hydrochloric acid for samples 5-7, nitric acid for samples 8 and 9, carbonic acid for sample 10, potassium hydroxide for samples 11-13, and malic acid for sample 14.

Table 2

| | | sample 5 | sample 6 | sample 7 | sample 8 | sample 9 | sample 10 | sample 11 | sample 12 | sample 13 | sample 14 |
|---|---|---|---|---|---|---|---|---|---|---|---|
| abrasive | abrasive grain | $SiO_2$ | $SiO_2$ | $SiO_2$ | $SiO_2$ | $SiO_2$ | $SiO_2$ | $SiO_2$ | $SiO_2$ | $SiO_2$ | $SiO_2$ |
| | pH | 0.8 | 1.0 | 1.5 | 2.0 | 2.0 | 6.0 | 10 | 12 | 13 | 2.0 |
| | additive | hydrochloric acid | hydrochloric acid | hydrochloric acid | nitric acid | nitric acid | carbonic acid | KOH | KOH | KOH | malic acid |
| CMP condition | pad compressibility (%) | 15 | 15 | 15 | 8 | 15 | 15 | 15 | 15 | 15 | 15 |
| | pressure ($g/cm^2$) | 300 | 300 | 300 | 300 | 300 | 300 | 300 | 300 | 300 | 300 |
| CMP property | flatness (%) | 38 | 45 | 55 | 81 | 69 | 62 | 58 | 40 | 35 | 82 |
| | roughness (nm) | 1.5 | 0.90 | 0.62 | 0.52 | 0.42 | 0.56 | 0.71 | 0.83 | 1.2 | 0.43 |
| epitaxial property | PL strength | 35 | 48 | 61 | 84 | 73 | 68 | 62 | 45 | 39 | 86 |
| laser | yield (%) | 28 | 45 | 52 | 73 | 62 | 57 | 53 | 37 | 32 | 74 |

The compressibility of the pad was 15 % for samples 5-7 and 9-14. It was 8 % for sample 8. The pressure on a wafer (substrate) was 300 g/cm$^2$ (29.4 kPa) for each of samples 5-14. After CMP, the flatness and surface roughness Ra of the samples were examined. Flatness is the proportion of the area having an off angle of less than 0.1°. At least 40 % is necessary. At least 60 % is desirable.

While it is not simple in consideration of other conditions such as pad compressibility, as based solely on this result, samples 5 and 13 respectively showed 38 % and 35 %, indicating low in flatness and not being conformable. Samples 6 and 12 respectively showed 45 % and 40 %, being conformable. Samples 7 and 11 respectively showed 55 % and 58 %, being further excellent. Samples 9 and 10 respectively showed at least 60 %, being further excellent Samples 8 and 14 respectively showed at least 80 %, being further excellent. In order to improve flatness, the abrasive liquid must not be strong acid or strong alkaline. pH of 1-12 provides flatness of at least 40 %. pH of 1.5 - 10 provides flatness of at least 55 %. Desirably, the abrasive liquid is acid. When at least 60 % flatness is to be obtained, pH should be 2-6 (acid). Flatness can further be improved by using organic acid rather than inorganic acid.

As to surface roughness, samples 5 and 13 showed 1 nm or higher, being relatively poor. Samples 6, 7, 11 and 12 were relatively good. Samples 8, 9, 10 and 14 showed 0.6 nm or lower, being further excellent. When abrasive liquid is strongly acid or alkaline, selectively corrodes crystal defect gathering region 13, whereby surface roughness and flatness become poor.

Suitable pH is 2-6. Depending on the purpose, pH of about 1-12 may be used. As to acid abrasive liquid, flatness is more improved by use of organic acid such as malic acid or citric acid than by use of inorganic acid. While inorganic acid selectively corrodes crystal defect gathering region 13, organic acid less exhibits such an action. This is considered to be contributing to the flatness.

After CMP was performed, an epitaxial layer was deposited thereon through the MOCVD method. The PL (photoluminescence) light emission was examined. Epitaxial property is PL strength (in arbitrary unit). Samples 5 and 13 respectively showed 35 and 39, being particularly weak. Samples 6, 7, 11, and 12 respectively showed 48, 61, 62 and 45, exhibiting sufficient PL strength. Samples 8, 9, 10 and 14 showed considerably high PL strength (84, 73, 68, and 86). Samples 5 and 13 had their crystal defect gathering region 13 corroded by strong acid or alkali, resulting in poor flatness and high roughness. This resulted in poor quality of the epitaxial layer and low PL strength.

Further, various nitride layers were epitaxially grown on the substrate, and electrodes were provided to obtain blue laser devices having a wavelength of 430 nm. It was separated into chips and property of LD light emission and the yield of conforming items were examined. Samples 5 and 13 were respectively 28 and 32, being particularly poor. This is because of the strong acid and alkaline abrasive liquids. Samples 11 and 12 were respectively 53 and 37, being relatively poor. This may also be understood that the alkaline abrasive liquid corroded crystal defect gathering region 13 and flatness and surface roughness became poor. Sample 14 showed a 74 % yield, being excellent. Samples 8, 9 and 10 respectively showed 73 %, 62 %, and 57 % yields, from which it can be seen that excellent substrates were obtained.

Example 3: The effect of pad compressibility

With sample 1 ("S perpendicular G") in Example 1, conditions were varied (five types) and CMP was performed. Specifically, pad compressibility was varied. Since crystal defect gathering region 13 is weak and easily abraded, a pad that easily deforms may enter the abraded and recessed crystal defect gathering region 13, thereby further deeply abrade crystal defect gathering region 13.

Sample 1 was prepared as follows. On an alumina block measuring 135 mm outer diameter and 30 mm thickness as abrading holder 53, three GaN wafers (substrates) measuring 50 mm $\phi$ diameter and having stripes with 400 $\mu$m pitch were adhered by solid wax so that stripe direction S was perpendicular to rotation direction G (radially). Then grinding and lapping were performed. After grinding and diamond lapping were performed with diamond grindstone No. 2000, CMP was performed under the conditions shown in Table 3. Samples 15-21 were obtained.

For each of the samples 15-21, the loose abrasive grain was colloidal silica (SiO$_2$). For each of the samples 15-21, pH = 11 (alkaline). It had been known that pH = 11 was excessively strong alkaline and not in a suitable range in Example 2. On the other hand, this knowledge was based on the high pad compressibility such as 15 % or 8%. Therefore, considering that a lower pad compressibility might yield a favorable result, a further experiment was conducted with the bad condition of pH = 11. The pH adjusting component of the abrasive liquid was KOH.

Table 3

| | | sample 15 | sample 16 | sample 17 | sample 18 | sample 19 | sample 20 | sample 21 |
|---|---|---|---|---|---|---|---|---|
| abrasive | abrasive grain | $SiO_2$ | $SiO_2$ | $SiO_2$ | $SiO_2$ | $SiO_2$ | $SiO_2$ | $SiO_2$ |
| | pH | 11 | 11 | 11 | 11 | 11 | 11 | 11 |
| | additive | KOH | KOH | KOH | KOH | KOH | KOH | KOH |
| CMP condition | pad compressibility (%) | 0.8 | 1.0 | 1.5 | 3 | 10 | 15 | 20 |
| | pressure (g/cm$^2$) | 300 | 300 | 300 | 300 | 300 | 300 | 300 |
| CMP property | flatness (%) | 90 | 87 | 85 | 80 | 60 | 40 | 35 |
| | roughness (nm) | 2.3 | 0.9 | 0.53 | 0.42 | 0.45 | 0.55 | 1.4 |
| epitaxial property | PL strength | 35 | 75 | 90 | 84 | 66 | 47 | 36 |
| laser | yield (%) | 26 | 70 | 78 | 71 | 56 | 42 | 27 |

Pad compressibility was 0.8 % for sample 15; 1.0 % for sample 16; 1.5 % for sample 17; 3 % for sample 18; 10 % for sample 19; 15 % for sample 20; and 20 % for sample 21. That is, the compressibility is increased in this order.

The pressure on a wafer was 300 g/cm$^2$ (29.4 kPa) for each of samples 15-21.

After CMP, the flatness and surface roughness Ra of the samples were examined Sample 21 showed flatness 35 %, being the lowest. Sample 20 showed flatness 40 %, and sample 19 showed flatness 60 %, being improved. Comparing samples 21, 20 and 19 with each other, it can be seen that an excessively high compressibility fails to attain flatness. When compressibility is at most 15 %, flatness is at least 40 %. In order to achieve the flatness of at least 60 %, compressibility must be at most 10 %. In order to achieve the flatness of at least 80 %, compressibility should be at most 3 %.

Sample 15 showed roughness Ra 2.3 nm, being the highest. Sample 16 showed Ra 0.9 nm, being improved. With the pad having low compressibility, the abrasive grain strongly strikes the group III nitride substrate during abrading and the surface roughness becomes high. Accordingly, pad compressibility must be at least 1%.

Sample 21 showed roughness Ra 1.4 nm, being relatively high. Sample 20 showed Ra 0.55 nm, being improved. Samples 18 and 19 showed excellent surface roughness (Ra 0.42 nm and Ra 0.45 nm, respectively). A pad having high compressibility may easily deform and enter the recessed crystal defect gathering region 13. Accordingly, crystal defect gathering region 13 may particularly be corroded and the recesses and protrusions may become prominent. The surface loses flatness, and the surface roughness becomes high. Therefore, pad compressibility must be at most 15 %. More preferably, it is at most 10 %. Further preferably, it is at most 3 %.

After CMP was performed, an epitaxial layer was deposited thereon through the MOCVD method. The PL (photoluminescence) light emission was examined. Epitaxial property is PL strength (in arbitrary unit). Samples 15 and 21 respectively showed 35 and 36, being particularly weak. Sample 17 showed 90, exhibiting sufficient PL strength. Samples 16 and 18 showed considerably high PL strength (75 and 84). Pad compressibility for sample 15 was small and the abrasive grain strongly struck the group III nitride crystal, whereby the surface roughness became high. This resulted in weak PL strength. Pad compressibility of sample 21 was high and the pad easily deformed. Therefore, the pad entered the recessed crystal defect gathering region 13 and deeply abraded the same. This resulted in high surface roughness, poor flatness, occurrence of over-abraded circumference, and weak PL strength.

Further, various nitride layers were epitaxially grown on the substrate, and electrodes were provided to obtain a laser device. It was separated into chips and property of LD light emission and the yield of conforming items were examined. Sample 21 showed a 27% yield, being poor. This may also be understood that the crystal defect gathering region 13 was abraded because of the high compressibility, resulting in poor flatness and surface roughness. Sample 15 showed a 26 % yield, being poor. This may be attributed to the high surface roughness. Samples 16, 17 and 18 respectively showed 70 %, 78 %, and 71 % yields, being excellent. Samples 20 and 19 respectively showed 42 % and 56 % yields.

Based on the foregoing result, pad compressibility must be at most 15 %. More preferably, it is at most 10 %. Further preferably, it is at most 3 %.

Example 4: The effect of pressure

With sample 1 ("S perpendicular G") in Example 1, conditions were varied (nine types) and CMP was performed. Specifically, pressure was varied. Crystal defect gathering region 13 is weak and easily abraded. Low pressure on the pad may reduce the abrading rate of low defect single crystal region 11 and C-plane growth region 12 and increase the removal ratio of crystal defect gathering region 13 being poor in chemical resistance, resulting in low flatness. High pressure may deform the pad, whereby the pad may deeply abrade crystal defect gathering region 13, resulting in low flatness. The force which presses the abrasive grain may also become great, resulting in an increased surface roughness Ra. Therefore, the effect of pressure must also be examined.

Sample 1 was prepared as follows. On an alumina block measuring 13 5 mm outer diameter and 30 mm thickness as abrading holder 53, three GaN wafers (substrates) measuring 50 mm $\phi$ diameter and having stripes with 400 $\mu$m pitch were adhered by solid wax so that stripe direction S was perpendicular to rotation direction G (radially). Then grinding and lapping were performed. After grinding and diamond lapping were performed with diamond grindstone No. 2000, CMP was performed under the conditions shown in Table 4. Samples 22-30 were obtained.

For each of the samples 22-30, the loose abrasive grain was colloidal silica ($SiO_2$). For each of the samples 22-30, pH = 2.5 (acid). Additive for pH adjustment was $HNO_3$ (nitric acid). It had been known that pH = 2.5 being acid was a suitable pH range in Example 2. Since pressure was to be varied, pH of the suitable range was selected.

Table 4

| | | sample 22 | sample 23 | sample 24 | sample 25 | sample 26 | sample 27 | sample 28 | sample 29 | sample 30 |
|---|---|---|---|---|---|---|---|---|---|---|
| abrasive | abrasive grain | $SiO_2$ | $SiO_2$ | $SiO_2$ | $SiO_2$ | $SiO_2$ | $SiO_2$ | $SiO_2$ | $SiO_2$ | $SiO_2$ |
| | pH | 2.5 | 2.5 | 2.5 | 2.5 | 2.5 | 2.5 | 2.5 | 2.5 | 2.5 |
| | additive | $HNO_3$ | $HNO_3$ | $HNO_3$ | $HNO_3$ | $HNO_3$ | $HNO_3$ | $HNO_3$ | $HNO_3$ | $HNO_3$ |
| CMP condition | pad compressibility (%) | 3 | 3 | 3 | 3 | 3 | 3 | 3 | 3 | 3 |
| | pressure (g/cm$^2$) | 80 | 100 | 150 | 300 | 500 | 800 | 1000 | 1500 | 1600 |
| CMP property | flatness (%) | 38 | 50 | 55 | 67 | 85 | 82 | 70 | 61 | 52 |
| | roughness (nm) | 0.52 | 0.40 | 0.39 | 0.45 | 0.54 | 0.83 | 1.0 | 2.0 | 2.5 |
| epitaxial property | PL strength | 41 | 51 | 59 | 78 | 91 | 88 | 68 | 43 | 12 |
| laser | yield (%) | 34 | 43 | 49 | 67 | 75 | 65 | 57 | 40 | 8 |

Pad compressibility was 3 % for each of samples 22-30. The pressure on a wafer was 80 g/cm$^2$ (7.8 kPa) for sample 22; 100 g/cm$^2$ (9.8 kPa) for sample 23; 150 g/cm$^2$ (14.7 kPa) for sample 24; 300 g/cm$^2$ (29.4 kPa) for sample 25; 500 g/cm$^2$ (49 kPa) for sample 26; 800 g/cm$^2$ (78.4 kPa) for sample 27; 1000 g/cm$^2$ (98.0 kPa) for sample 28; 1500 g/cm$^2$ (118 kPa) for sample 29; and 1600 g/cm$^2$ (157 kPa) for sample 30.

After CMP, the flatness and surface roughness Ra of the samples were examined. Sample 22 showed flatness 38 %, being the lowest. Sample 23 showed flatness 50 %, being improved. Samples 26 and 27 respectively showed flatness 85 % and 82 %, being excellent. Sample 30 with high pressure showed flatness 52 %, being low. Too high or low pressure on the pad impaired flatness.

Sample 30 showed surface roughness of Ra 2.5 nm, being too high. Sample 29 showed Ra 2.0 nm, being improved. Samples 24 and 23 showed excellent surface roughness (Ra 0.39 nm, Ra 0.40 nm, respectively). Higher pressure resulted in higher surface roughness, whereby the quality of the surface was deteriorated.

Too low pressure reduces the abrading rate of low defect single crystal region 11 and C-plane growth region 12, which are physically and chemically strong, while only weak crystal defect gathering region 13 is abraded. Thus, flatness becomes low. Too high pressure deforms the pad, whereby weak crystal defect gathering region 13 is greatly abraded and the flatness is impaired. Since the pressing pressure is great, the surface roughness is also greatly deteriorated.

Based on the foregoing result, the pressure must be 100 g/cm$^2$ (9.8 kPa) - 1500 g/cm$^2$ (147 kPa). More preferably, it must be 300 g/cm$^2$ (29.4 kPa) - 1000 g/cm$^2$ (98 kPa).

After CMP was performed, an epitaxial layer was deposited thereon through the MOCVD method. The PL (photoluminescence) light emission was examined. Epitaxial property in the table is PL strength (in arbitrary unit). Sample 30 showed 12, being particularly weak. Samples 26 and 27 showed 91 and 88, exhibiting sufficient PL strength. Samples 25 and 28 showed considerably high PL strength (78 and 68). Pressure applied from the pad on the wafer for sample 30 was too high, whereby crystal defect gathering region 13 was abnormally abraded. Since flatness was low and surface roughness was great, the quality of the epitaxial layer was deteriorated.

Further, various nitride layers were epitaxially grown on the substrate, and electrodes were provided to obtain laser devices. It was separated into chips and property of LD light emission and the yield of conforming items were examined. Sample 30 showed a 8% yield, being extremely poor. Sample 22 showed a 34% yield, being poor. Sample 25 showed a 75 % yield, being excellent. Based on the foregoing result, it can be seen that the pressure should not be too high or low.

The pressure applied on the pad must be 100 g/cm$^2$ (9.8 kPa) - 1500 g/cm$^2$ (147 kPa). More preferably, it must be 300 g/cm$^2$ (29.4 kPa) - 1000 g/cm$^2$ (98 kPa).

Although the present invention has been described and illustrated in detail, it is clearly understood that the same is by way of illustration and example only and is not to be taken by way of limitation, the spirit and scope of the present invention being limited only by the terms of the appended claims.

**Claims**

1. A manufacturing method of a group III nitride substrate (1, 2), comprising the steps of:

   adhering a plurality of the stripe type group III nitride substrates (1, 2) to an abrading holder (53) so that a stripe structure direction is perpendicular to a rotation direction of said abrading holder (53); and
   grinding, lapping and/or polishing said substrates (1, 2).

2. The manufacturing method of the group III nitride substrate (1, 2) according to claim 1, wherein
   in said step of polishing said substrates (1, 2), said substrates (1, 2) are polished by: using an abrading surface plate (52) having a pad of which compressibility is 1 % - 15 %; setting pressure applied from said pad (51) of said abrading surface plate (52) to said substrates (1, 2) to 100 g/cm$^2$ (9.8 kPa) - 1500 g/cm$^2$ (147 kPa); and rotating said abrading holder (53) and said abrading surface plate (52) while supplying an abrasive liquid (54) of which pH is 1-12.

3. The manufacturing method of the group III nitride substrate (1, 2) according to claim 2, wherein
   a range of the compressibility of said pad (51) is 1 % - 10 %.

4. The manufacturing method of the group III nitride substrate (1, 2) according to claim 2, wherein
   the pressure applied from said pad (51) to said substrates (1, 2) is 300 g/cm$^2$ (29.4 kPa) - 1000 g/cm$^2$ (98 kPa).

5. The manufacturing method of the group III nitride substrate (1, 2) according to claim 2, wherein

pH of said abrasive liquid (54) is pH = 1.5 - 10.

6. The manufacturing method of the group III nitride substrate (1, 2) according to claim 5, wherein pH of said abrasive liquid (54) is pH = 2 - 7.

7. The manufacturing method of the group III nitride substrate (1, 2) according to claim 2, wherein acid added to said abrasive liquid (54) for adjusting pH is organic acid or salt of organic acid.

8. A group III nitride substrate (2) prepared through a vapor phase deposition method, comprising a stripe structure, in which: a crystal defect gathering region (13) that has dislocations gathered therein and that has a nitrogen plane as its top plane; and a low defect single crystal region (11) that is lower in a dislocation density than said crystal defect gathering region (13) and that has a group III element plane as its top plane, are repeatedly aligned in a linear and parallel manner, wherein said substrate (2) is obtained by polishing said substrate (2) by: using an abrading surface plate (52) having a pad of which compressibility is 1 % - 15 %; setting pressure applied from said pad (51) of said abrading surface plate (52) to said substrate (2) to 100 $g/cm^2$ (9.8 kPa) - 1500 $g/cm^2$ (147 kPa); and rotating said abrading holder (53) and said abrading surface plate (52) while supplying an abrasive liquid (54) of which pH is 1-12, wherein flatness, which is a proportion of an area having an off angle of less than 0.1° relative to a direction perpendicular to said stripe structure, is at least 40 %, and wherein surface roughness is at most Ra 2 nm.

9. The group III nitride substrate (2) according to claim 8, obtained by polishing said substrate (2) as adhered to said abrading holder (53) so that a direction of said stripe structure is perpendicular to a direction of rotation of said abrading holder (53).

10. A group III nitride substrate (7) with an epitaxial layer, comprising:

   the group III nitride substrate (2) according to claim 8; and
   at least one layer of a group III nitride layer (3) formed by epitaxial growth on at least one main surface of said substrate (2).

11. A group III nitride device, comprising:

   the group III nitride substrate (2) according to claim 8;
   at least one layer of a group III nitride layer (3) formed by epitaxial growth on at least one main surface of said substrate (2); and
   an electrode formed at said substrate (2) or said group III nitride layer (3).

12. A manufacturing method of a group III nitride substrate (7) with an epitaxial layer, comprising the steps of:

   preparing the group III nitride substrate (2) according to claim 8; and
   epitaxially growing a group III nitride layer (3) on at least one main surface of said substrate (2).

13. A manufacturing method of group III nitride device, comprising the steps of:

   preparing the group III nitride substrate (2) according to claim 8;
   epitaxially growing a group III nitride layer (3) on at least one main surface of said substrate (2); and
   forming an electrode at said substrate (2) or said group III nitride layer (3).

14. A group III nitride substrate (I) prepared through a vapor phase deposition method, comprising a stripe structure, in which: a crystal defect gathering region (13) that has dislocations gathered therein and that has a nitrogen plane as its top plane; a low defect single crystal region (11) that is lower in a dislocation density than said crystal defect gathering region (13) and that has a group III element plane as its top plane; and a C-plane growth region (12), are repeatedly aligned in a linear and parallel manner, wherein said substrate (1) is obtained by polishing said substrate (1) by: using an abrading surface plate (52) having a pad of which compressibility is 1 % - 15 %; setting pressure applied from said pad (51) of said abrading surface plate (52) to said substrate (1) to 100 $g/cm^2$ (9.8 kPa) - 1500 $g/cm^2$ (147 kPa); and rotating said abrading holder (53) and said abrading surface plate (52) while supplying an abrasive liquid (54) of which pH is 1-12, wherein

flatness, which is a proportion of an area having an off angle of less than 0.1° relative to a direction perpendicular to said stripe structure, is at least 40 %, and wherein
surface roughness is at most Ra 2 nm.

15. The group III nitride substrate (1) according to claim 14, obtained by polishing said substrate (1) as adhered to said abrading holder (53) so that a direction of said stripe structure is perpendicular to a direction of rotation of said abrading holder (53).

16. A group III nitride substrate (7) with an epitaxial layer, comprising:

    the group III nitride substrate (1) according to claim 14; and
    at least one layer of a group III nitride layer (3) formed by epitaxial growth on at least one main surface of said substrate (1).

17. A group III nitride device, comprising:

    the group III nitride substrate (1) according to claim 14,
    at least one layer of a group III nitride layer (3) formed by epitaxial growth on at least one main surface of said substrate (1); and
    an electrode formed at said substrate (1) or said group III nitride layer (3).

18. A manufacturing method of a group III nitride substrate (7) with an epitaxial layer, comprising the steps of:

    preparing the group III nitride substrate (1) according to claim 14; and
    epitaxially growing a group III nitride layer (3) on at least one main surface of said substrate (1).

19. A manufacturing method of group III nitride device, comprising the steps of:

    preparing the group III nitride substrate (1) according to claim 14;
    epitaxially growing a group III nitride layer (3) on at least one main surface of said substrate (1); and
    forming an electrode at said substrate (1) or said group III nitride layer (3).

FIG.1

FIG.2

FIG.3

FIG.4

FIG.5

FIG.6

FIG.7

FIG.8

```
┌─────────────────────────────────────┐
│              ADHERE                  │
└─────────────────────────────────────┘
                  │
┌─────────────────────────────────────┐
│  GRINDING, LAPPING AND/OR POLISHING  │
└─────────────────────────────────────┘
```

FIG.9

FIG.10

FIG.11

Z Y Z H Z Y Z H Z Y Z H Z Y Z H Z Y Z

13 11 12 11

FIG.12

Z H Z H Z H Z H Z H Z H Z H Z H Z H Z

13 11 13

FIG.13

| PREPARE GROUP III NITRIDE SUBSTRATE |

| EPITAXIALLY GROW GROUP III NITRIDE LAYER |

FIG.14

| PREPARE GROUP III NITRIDE SUBSTRATE |

| EPITAXIALLY GROW GROUP III NITRIDE LAYER |

| FORM ELECTRODES |

**European Patent Office** — **EUROPEAN SEARCH REPORT**

Application Number

EP 07 01 6218

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2005/109481 A (NITTA HAAS INC [JP]; SUMITOMO ELECTRIC INDUSTRIES [JP]; KATOH HIROKI;) 17 November 2005 (2005-11-17) * abstract * | 1-19 | INV. C30B29/40 H01L21/306 |
| P,X | US 2006/283840 A1 (MATSUMOTO NAOKI [JP]) 21 December 2006 (2006-12-21) * the whole document * | 1 | |
| X | & WO 2006/075527 A (SUMITOMO INDUSTRIES LTD) 20 July 2006 (2006-07-20) * the whole document * | 1 | |
| A,D | JP 2004 165360 A (HITACHI CABLE) 10 June 2004 (2004-06-10) * abstract * | 1 | |
| A | EP 1 304 749 A (SUMITOMO ELECTRIC INDUSTRIES [JP]) 23 April 2003 (2003-04-23) * page 12, line 46 - line 48; figure 10(5) * | 1 | |
| A,D | & JP 2003 183100 A (SUMITOMO) 3 July 2003 (2003-07-03) | | TECHNICAL FIELDS SEARCHED (IPC) |
| A | EP 1 088 914 A (SUMITOMO ELECTRIC INDUSTRIES [JP]) 4 April 2001 (2001-04-04) | | C30B H01L |
| A,D | & JP 2001 102307 A (SUMITOMO) 13 April 2001 (2001-04-13) | | |
| A | EP 1 296 362 A (SUMITOMO ELECTRIC INDUSTRIES [JP]) 26 March 2003 (2003-03-26) | | |
| A,D | & JP 2003 165799 A (SUMITOMO) 10 June 2003 (2003-06-10) | | |
| A | US 2006/029832 A1 (XU XUEPING [US] ET AL) 9 February 2006 (2006-02-09) | | |

The present search report has been drawn up for all claims

| Place of search | Date of completion of the search | Examiner |
|---|---|---|
| The Hague | 14 December 2007 | Cook, Steven |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
...................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 01 6218

This annex lists the patent family members relating to the patent documents cited in the above-mentioned European search report.
The members are as contained in the European Patent Office EDP file on
The European Patent Office is in no way liable for these particulars which are merely given for the purpose of information.

14-12-2007

| Patent document cited in search report | | Publication date | Patent family member(s) | | Publication date |
|---|---|---|---|---|---|
| WO 2005109481 | A | 17-11-2005 | NONE | | |
| US 2006283840 | A1 | 21-12-2006 | CN | 1906739 A | 31-01-2007 |
| | | | EP | 1814149 A1 | 01-08-2007 |
| | | | JP | 2006196609 A | 27-07-2006 |
| | | | WO | 2006075527 A1 | 20-07-2006 |
| | | | KR | 20060135672 A | 29-12-2006 |
| WO 2006075527 | A | 20-07-2006 | CN | 1906739 A | 31-01-2007 |
| | | | EP | 1814149 A1 | 01-08-2007 |
| | | | JP | 2006196609 A | 27-07-2006 |
| | | | KR | 20060135672 A | 29-12-2006 |
| | | | US | 2006283840 A1 | 21-12-2006 |
| JP 2004165360 | A | 10-06-2004 | NONE | | |
| EP 1304749 | A | 23-04-2003 | CA | 2406347 A1 | 09-04-2003 |
| | | | CN | 1411035 A | 16-04-2003 |
| | | | JP | 3801125 B2 | 26-07-2006 |
| | | | JP | 2003183100 A | 03-07-2003 |
| | | | KR | 20030030917 A | 18-04-2003 |
| | | | TW | 234293 B | 11-06-2005 |
| | | | US | 2003145783 A1 | 07-08-2003 |
| JP 2003183100 | A | 03-07-2003 | CA | 2406347 A1 | 09-04-2003 |
| | | | CN | 1411035 A | 16-04-2003 |
| | | | EP | 1304749 A1 | 23-04-2003 |
| | | | JP | 3801125 B2 | 26-07-2006 |
| | | | KR | 20030030917 A | 18-04-2003 |
| | | | TW | 234293 B | 11-06-2005 |
| | | | US | 2003145783 A1 | 07-08-2003 |
| EP 1088914 | A | 04-04-2001 | CN | 1289865 A | 04-04-2001 |
| | | | CN | 1870223 A | 29-11-2006 |
| | | | CN | 1908251 A | 07-02-2007 |
| | | | DE | 60033610 T2 | 21-06-2007 |
| | | | JP | 2001102307 A | 13-04-2001 |
| | | | KR | 20010050558 A | 15-06-2001 |
| | | | TW | 508836 B | 01-11-2002 |
| | | | US | 6468347 B1 | 22-10-2002 |
| JP 2001102307 | A | 13-04-2001 | CN | 1289865 A | 04-04-2001 |
| | | | CN | 1870223 A | 29-11-2006 |
| | | | CN | 1908251 A | 07-02-2007 |
| | | | DE | 60033610 T2 | 21-06-2007 |
| | | | EP | 1088914 A1 | 04-04-2001 |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 07 01 6218

This annex lists the patent family members relating to the patent documents cited in the above-mentioned European search report.
The members are as contained in the European Patent Office EDP file on
The European Patent Office is in no way liable for these particulars which are merely given for the purpose of information.

14-12-2007

| Patent document cited in search report | Publication date | Patent family member(s) | Publication date |
|---|---|---|---|
| JP 2001102307 A | | KR 20010050558 A<br>TW 508836 B<br>US 6468347 B1 | 15-06-2001<br>01-11-2002<br>22-10-2002 |
| EP 1296362 A | 26-03-2003 | CA 2403310 A1<br>CN 1405903 A<br>JP 3864870 B2<br>JP 2003165799 A<br>KR 20030025216 A<br>TW 230468 B<br>US 2003080345 A1 | 19-03-2003<br>26-03-2003<br>10-01-2007<br>10-06-2003<br>28-03-2003<br>01-04-2005<br>01-05-2003 |
| JP 2003165799 A | 10-06-2003 | CA 2403310 A1<br>CN 1405903 A<br>EP 1296362 A2<br>JP 3864870 B2<br>KR 20030025216 A<br>TW 230468 B<br>US 2003080345 A1 | 19-03-2003<br>26-03-2003<br>26-03-2003<br>10-01-2007<br>28-03-2003<br>01-04-2005<br>01-05-2003 |
| US 2006029832 A1 | 09-02-2006 | NONE | |

EPO FORM P0459

For more details about this annex : see Official Journal of the European Patent Office, No. 12/82

**REFERENCES CITED IN THE DESCRIPTION**

**Patent documents cited in the description**

- JP 2004165360 A
- JP 2001102307 A
- JP 2003165799 A
- JP 2003183100 A